# EUROPÄISCHE PATENTSCHRIFT

(11) **EP 2 274 508 B1**
(45) Veröffentlichungstag und Bekanntmachung des Hinweises auf die Patenterteilung: **19.10.2011**
(21) Anmeldenummer: 09745492.0
(22) Anmeldetag: 21.04.2009
(51) Int. Cl.: F01N 5/02, H01L 35/00, H01L 35/30, F01N 9/00, F02G 5/02

(54) **ABGASANLAGE FÜR EINE BRENNKRAFTMASCHINE**
EXHAUST GAS SYSTEM FOR AN INTERNAL COMBUSTION ENGINE
SYSTÈME D'ÉCHAPPEMENT DE MOTEUR À COMBUSTION INTERNE

(30) Priorität: 15.05.2008 DE 102008023831
(43) Veröffentlichungstag der Anmeldung: 19.01.2011
(73) Patentinhaber: Bayerische Motoren Werke Aktiengesellschaft, 80809 München (DE)
(72) Erfinder: RICHTER, Rainer, 81247 München (DE)
(86) Internationale Anmeldenummer: PCT/EP2009/002885
(87) Internationale Veröffentlichungsnummer: WO 2009/138158

(56) Entgegenhaltungen:
- EP-A- 1 475 532
- JP-A- 6 081 639
- JP-A- 7 012 009
- JP-A- 2004 360 522
- JP-A- 2006 034 046
- JP-A- 2008 104 317

## Beschreibung

Die Erfindung betrifft eine Abgasanlage für eine Brennkraftmaschine mit den Merkmalen aus dem Oberbegriff des Patentanspruchs 1.

Zum technischen Umfeld wird beispielsweise auf die europäische Patentanmeldung EP 1 475 532 A2 hingewiesen. Aus dieser ist eine Brennkraftmaschine bekannt mit einer Sauganlage und einer Abgasanlage, wobei die Abgasanlage und die Sauganlage über eine Abgasrückführeinrichtung miteinander gasführend verbunden sind. An die Abgasrückführeinrichtung ist ein thermoelektrischer Generator angeordnet, um aus der Abgaswärmeenergie Strom zu gewinnen. Um eine optimale Wärmezufuhr zu dem thermoelektrischen Generator über die Abgasrückführleitung zu gewährleisten, sind vor und hinter dem thermoelektrischen Generator in der Abgasrückführleitung Ventile angeordnet, die von einem Steuergerät betriebspunktabhängig angesteuert werden. Um eine optimale Temperaturdifferenz zwischen der Heißseite und der Kaltseite des thermoelektrischen Generators zu erzielen, ist der thermoelektrische Generator mit seiner Kaltseite an einen Kühlmittelkreislauf angebunden.

Weiter ist aus der japanischen Offenlegungsschrift JP 7012009 A2, von der diese Erfindung ausgeht, die Anordnung von thermoelektrischen Generatoren an die Abgasanlage einer Brennkraftmaschine bekannt, wobei der Abgasstrang in mehrere, parallele abgasführende Zweige aufgeteilt ist. An jedem dieser Zweige sind zwei thermoelektrische Generatoren angeordnet, wodurch eine optimale Stromerzeugung bei geringsten Abgasgegendrücken erzielbar ist. Weiter kann mit dieser verzweigten Abgasanlage deutlich Bauraum eingespart werden.

Nachteilig an der aus dem Stand der Technik bekannten Anordnung von thermoelektrischen Generatoren ist der relativ schmale Drehzahl- bzw. Lastbereich der Brennkraftmaschine, in dem die thermoelektrischen Generatoren optimal funktionieren, da der Wirkungsgrad sehr stark von der Abgastemperatur abhängig ist. Darüber hinaus besteht die Gefahr einer Überhitzung, wenn die Brennkraftmaschine über längere Zeit in einem hohen Drehzahl- bzw. Lastbereich betrieben wird.

Aufgabe der vorliegenden Erfindung ist es, oben genannte Nachteile zu vermeiden sowie den Wirkungsgrad der Stromerzeugung mit thermoelektrischen Generatoren zu verbessern.

Diese Aufgabe wird durch das Merkmal im kennzeichnenden Teil des Patentanspruchs 1 gelöst.

In einer einfachsten Ausführungsform ist der thermoelektrische Generator mit dem Wärmetauscher mit der geringeren Wärmeleitfähigkeit brennkraftmaschinennah und der zweite thermoelektrische Generator mit einem Wärmetauscher mit der höheren Wärmeleitfähigkeit brennkraftmaschinenfern angeordnet. Durch diese Maßnahme wird verhindert, dass der erste thermoelektrische Generator durch eine Überhitzung mit zu heißem Abgas zerstört wird, wobei gleichzeitig der zweite thermoelektrische Generator mit dem Wärmetauscher mit der höheren Wärmeleitfähigkeit, der mit dem bereits abgekühlten, kälteren Abgas in Wirkverbindung steht, durch die erfindungsgemäße Maßnahme einen höheren Wirkungsgrad bei niedrigeren Temperaturen aufweist.

Die Erfindung umfasst weiter eine erste und eine zweite besonders bevorzugte Ausführungsform, bzw. Ausführungsvariante.

Mit der Ausgestaltung gemäß Patentanspruch 2 wird für die erste besonders bevorzugte Ausführungsvariante ein sehr guter Wirkungsgrad bei der Stromerzeugung erzielt.

Mit der Ausgestaltung gemäß Patentanspruch 3 wird für die zweite besonders bevorzugte Ausführungsvariante ebenfalls ein sehr guter Wirkungsgrad bei der Stromerzeugung erzielt.

Die Steuerung gemäß Patentanspruch 4 ist besonders bevorzugt. Ist das Steuergerät ein Brennkraftmaschinensteuergerät erlaubt dies in vorteilhafter Weise auch eine Kennfeldsteuerung.

Mit der Ausgestaltung gemäß Patentanspruch 5 wird ein optimales Temperaturgefälle zwischen der Heißseite und der Kaltseite des thermoelektrischen Generators erzielt.

Mit der Ausgestaltung gemäß Patentanspruch 6 wird eine sehr schnelle Aufheizung der thermoelektrischen Generatoren erreicht.

Im Folgenden ist die Erfindung anhand von zwei besonders bevorzugten Ausführungsbeispielen in zwei Figuren näher erläutert:
- Fig. 1: zeigt schematisch eine erste erfindungsgemäße Ausführungsform für eine Abgasanlage für eine Brennkraftmaschine
- Fig. 2: zeigt schematisch eine zweite erfindungsgemäße Ausführungsform für eine Abgasanlage für eine Brennkraftmaschine

Im Folgenden gelten für gleiche Bauelemente in beiden Figuren die gleichen Bezugsziffern.

Unter thermoelektrischer Generator (TEG) wird im Folgenden ein Halbleiterbauelement verstanden, welches bei einer Temperaturdifferenz zwischen einer Heißseite und einer Kaltseite Strom erzeugt. Da thermoelektrische Generatoren bereits aus dem Stand der Technik hinreichend bekannt sind, werden diese in der vorliegenden Anmeldung nicht näher erläutert. Weiter kann unter einem thermoelektrischen Generator ein einzelnes Halbleiterbauelement verstanden werden sowie eine Verschaltung von mehreren einzelnen Halbleiterbauelementen zu einem Paket.

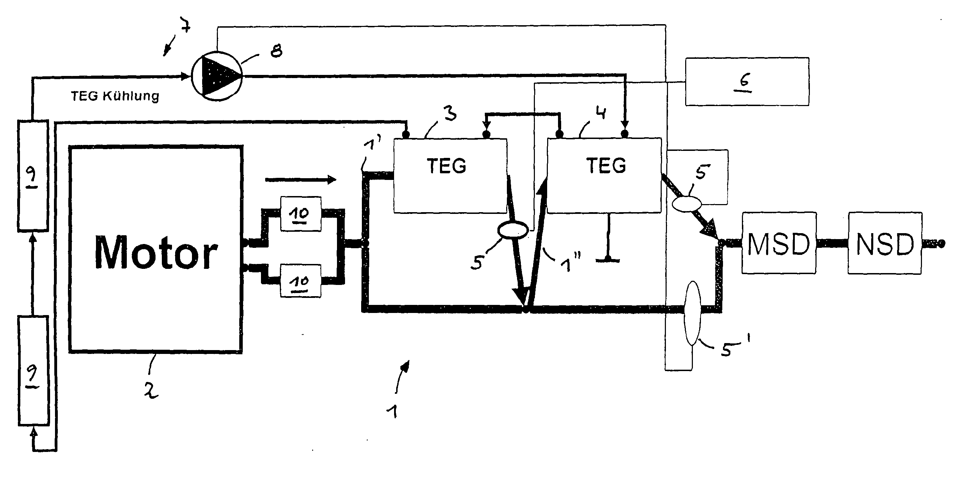

Fig. 1 zeigt schematisch ein erstes Ausführungsbeispiel für eine erfindungsgemäße Abgasanlage 1 für eine Brennkraftmaschine 2. An die Brennkraftmaschine 2 ist eine anfangs zweiflutige Abgasanlage 1 angeordnet, wobei jeder Flut eine Abgasreinigungsanlage 10 zugeordnet ist. In Strömungsrichtung eines Abgases der Brennkraftmaschine 2, nach den Abgasreinigungsanlagen 10 ist die Abgasanlage 1 einflutig ausgelegt. Anschließend weist die Abgasanlage einen ersten Bypass 1' auf, in dem ein erster thermoelektrischer Generator 3 angeordnet ist. Hinter dem ersten thermoelektrischen Generator 3 ist ein Verschlusselement 5 im Bypass 1' angeordnet. Nach dem Verschlusselement 5 mündet der erste Bypass 1' wieder gasführend in die Abgasanlage 1. Anschließend weist die Abgasanlage 1 einen zweiten Bypass 1" auf, in dem ein zweiter thermoelektrische Generator 4 angeordnet ist. Hinter dem zweiten thermoelektrischen Generator 4 ist ebenfalls ein Verschlusselement 5 im zweiten Bypass angeordnet, bevor der zweite Bypass 1" wieder gasführend in die Abgasanlage 1 mündet. Anschließend sind in der Abgasanlage 1 in Strömungsrichtung des Abgases zuerst ein nicht bezifferter Mittelschalldämpfer und anschließend ein ebenfalls nicht bezifferter Nachschalldämpfer angeordnet. Weiter ist parallel zum zweiten Bypass 1" in der Abgasanlage 1 ein Verschlusselement 5' für die Abgasanlage 1 angeordnet.

Die Verschlusselemente 5, 5' sind über ein Steuergerät 6, beispielsweise einem Brennkraftmaschinensteuergerät, vorzugsweise vom Betriebspunkt der Brennkraftmaschine abhängig über ein Kennfeld, ansteuerbar. Während die Heißseiten der thermoelektrischen Generatoren 3, 4 an die Abgasanlage 1 angeordnet und von dem Abgas der Brennkraftmaschine 2 aufheizbar sind, sind die Kaltseiten der thermoelektrischen Generatoren 3, 4 in dem vorliegenden Ausführungsbeispiel mit einem Kühlmittelkreislauf 7 in Wirkverbindung. Der Kühlmittelkreislauf 7 weist eine Kühlmittelpumpe 8 zur Förderung des Kühlmittels sowie zwei Wärmetauscher 9 zur Kühlung des Kühlmittels auf.

Jeder thermoelektrische Generator 3, 4 weist zwischen seiner Heißseite und seiner Kaltseite einen Wärmetauscher mit einer bestimmten Wärmeleitfähigkeit auf. Erfindungsgemäß ist die Wärmeleitfähigkeit Wärmetauschers des brennkraftmaschinennahen thermoelektrischen Generators 3 geringer als die des Wärmetauschers des zweiten thermoelektrischen Generators 4. Durch die erfindungsgemäße Ausgestaltung der Abgasanlage 1 wird der erste thermoelektrische Generator 3 mit einem heißeren Abgas beaufschlagt als der zweite thermoelektrische Generator 4. Aufgrund der unterschiedlichen Wärmeleitfähigkeiten der Wärmetauscher wird der Effekt, d. h. die Abkühlung des Abgases über die Länge der Abgasanlage 1, kompensiert, wodurch der Wirkungsgrad für die Gewinnung von elektrischen Strom der gesamten Anordnung deutlich vergrößert wird. Wird das Abgas bei bestimmten Betriebspunkten der Brennkraftmaschine zu heiß, so wird das Verschlusselement 5 hinter dem ersten thermoelektrischen Generator 3 geschlossen, so dass eine Überhitzung sicher vermieden ist. Das heiße Abgas wird nun nur noch durch den zweiten thermoelektrischen Generator 4 geleitet, der aufgrund des mittlerweile abgekühlten Abgases immer noch voll einsetzbar ist. Werden Drehzahl und/oder Last der Brennkraftmaschine noch weiter erhöht, so kann auch der Abgasmassenstrom durch den zweiten thermoelektrischen Generator 4 mit dem Verschlusselement 5 hinter dem zweiten thermoelektrischen Generator 4 abgeschaltet werden. Somit sind beide thermoelektrischen Generatoren 3, 4 vor einer Überhitzung sicher bewahrt. Mit dem Verschlusselement 5' in der Abgasanlage 1 kann in vorteilhafter Weise der gesamte Abgasmassenstrom durch die thermoelektrischen Generatoren 3, 4 geleitet werden, für eine schnellstmögliche Aufheizung zur Stromerzeugung.

In weiteren Ausführungsbeispielen können auch noch weitere thermoelektrische Generatoren in weiteren Bypässen vorgesehen werden, die wiederum Wärmetauscher mit unterschiedlichen Wärmeleitfähigkeiten aufweisen. Auch ist es möglich unter bestimmten Umständen auf den Kühlmittelkreislauf 7 zu verzichten, wenn beispielsweise eine Luftkühlung vorgesehen wird. Auch eine Reduzierung der zwei Wärmetauscher 9 auf einen einzigen großen Wärmetauscher oder mehr kleinere Wärmetauscher ist möglich. Auch können die Abgasreinigungsanlagen 10 in anderen Ausführungsbeispielen an anderen Orten in der Abgasanlage 1 integriert sein. Auch die Anordnung der Verschlusselemente 5, 5' kann in anderen Ausführungsbeispielen derart gestaltet werden, dass sie beispielsweise in Strömungsrichtung des Abgases vor den thermoelektrischen Generatoren 3, 4 angeordnet sind. Als Verschlusselemente 5, 5' können beispielsweise Abgasklappen oder Drehschieber zum Einsatz kommen. Bevorzugt weisen die Abgasanlage 1 rund die Bypässe 1', 1" für geringste Strömungsverluste die gleichen Abgas-Durchflussquerschitte auf.

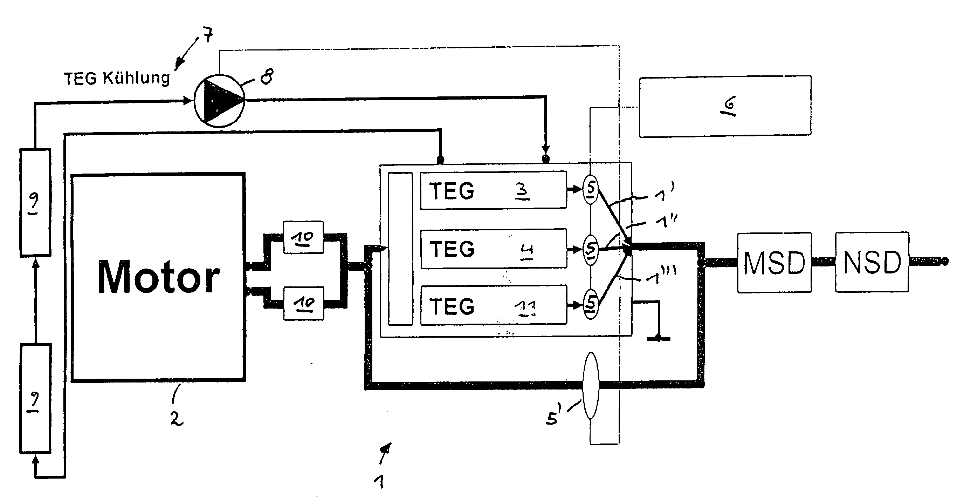

Fig. 2 zeigt schematisch in zweites besonders bevorzugtes Ausführungsbeispiel für die erfindungsgemäße Abgasanlage 1 für die Brennkraftmaschine 2. Das zweite besonders bevorzugte Ausführungsbeispiel unterscheidet sich vom ersten besonders bevorzugten Ausführungsbeispiel in Fig. 1 dadurch, dass die thermoelektrischen Generatoren 3, 4, 11 (in diesem Ausführungsbeispiel kommen drei thermoelektrische Generatoren zum Einsatz) in einem einzigen, gegabelten Bypass 1"' parallel zueinander angeordnet sind. Wie bereits im ersten besonders bevorzugten Ausführungsbeispiel weisen auch beim zweiten besonders bevorzugten Ausführungsbeispiel die thermoelektrischen Generatoren 3, 4, 11 jeweils Wärmetauscher mit unterschiedlichen Wärmeleitfähigkeiten auf. Somit kann das Abgas mit Hilfe der Verschlusselemente 5, die in Strömungsrichtung des Abgases hinter den thermoelektrischen Generatoren 3, 4, 11 angeordnet sind, entsprechend dem Betriebszustand der Brennkraftmaschine, d. h. abhängig von der Drehzahl bzw. von dem angeforderten Drehmoment, somit entsprechend der Abgastemperatur, jeweils einem oder auch zwei oder, wenn das Verschlusselement 5' in der Abgasanlage 1 geschlossen ist, auch durch alle drei thermoelektrischen Generatoren 3, 4, 11 geleitet werden. Sollte das Abgas aufgrund eines Betriebszustandes der Brennkraftmaschine durch hohe Last oder Drehzahl zu heiß werden, so dass eine thermische Zerstörung zumindest eines thermoelektrischen Generators 3, 4, 11 erfolgen könnte, können die Verschlusselemente 5 vollständig geschlossen werden, wobei dann nur noch, wie im ersten Ausführungsbeispiel beschrieben, der Abgasstrang 1 mit heißem Abgas durchströmt wird. Somit ist die thermische Zerstörung der thermoelektrischen Generatoren 3, 4, 11 sicher vermieden. Des Weiteren gelten sämtliche Ausführungen zum ersten besonders bevorzugten Ausführungsbeispiel auch für das zweite besonders bevorzugte Ausführungsbeispiel.

Eine praktische Anordnung des zweiten besonders bevorzugten Ausführungsbeispieles könnte folgendermaßen aussehen:
- Erster TEG 3:: Sehr aggressiver Heißgas-Wärmetauscher (beispielsweise hohe Rippendichte), maximale Leistung des thermoelektrischen Generators 3 im Bereich 30 - 70 km/h eines Fahrzeuges mit der erfindungsgemäßen Abgasanlage 1.
- Zweiter TEG 4:: Gegenüber Stufe 1 reduzierte Leistung des HeißgasWärmetauschers (z. B. reduzierte Rippendichte, Rippentyp), maximale Leistung des thermoelektrischen Generators im Bereich von 70 bis 130 km/h des Fahrzeuges mit der erfindungsgemäßen Abgasanlage 1.
- Dritter TEG 11:: Sehr schwacher Heißgaswärmetauscher, maximale Leistung des thermoelektrischen Generators im Bereich von 130 bis 180 km/h des Fahrzeuges mit der erfindungsgemäßen Abgasanlage 1.

Insgesamt ergeben sich folgende Vorteile durch die erfindungsgemäße Ausgestaltung der Abgasanlage 1:
❖ Gegenüber einem einstufigen TEG deutlich breiteres Einsatzspektrum.
❖ Durch optimierten Niedertemperatur TEG (Wärmetauscher mit einer sehr guten Wärmeleitfähigkeit) auch Nutzen im Stadtverkehr bzw. bei Niedriglastphasen (Geschwindigkeitsbereich von ca. 30 bis ca. 70 km/h)
❖ Durch optimierten Hochtemperatur TEG (Wärmetauscher mit einer sehr geringen Wärmeleitfähigkeit) thermische Rekuperation auch bei relativ hohen Geschwindigkeiten möglich, keine Überlastung des thermoelektrischen Materials, kein Gegendruckproblem durch schwachen Heißgaswärmetauscher (Geschwindigkeitsbereich von ca. 130 bis ca. 180 km/h)
❖ Optimierung des thermoelektrischen Generators im mittleren Geschwindigkeitsbereich (Geschwindigkeitsbereich von ca. 70 bis ca. 130 km/h) mit dem Ziel, einen optimalen Gesamtnutzen in dem Geschwindigkeitsfenster, das am meisten gefahren wird, zu erzielen.

### Bezugszeichenliste:

- 1.: Abgasanlage
- 1': erster Bypass
- 1": zweiter Bypass
- 1"': dritter Bypass
- 2.: Brennkraftmaschine
- 3.: erster TEG
- 4.: zweiter TEG
- 5.: Verschlusselement
- 5': Verschiusselement Abgasanlage
- 6.: Steuergerät
- 7.: Kühlmittelkreislauf
- 8.: Kühlmittelpumpe
- 9: Wärmetauscher
- 10.: Abgasreinigungsanlage
- 11.: dritter TEG

## Patentansprüche

1. Abgasanlage (1) für eine Brennkraftmaschine (2), wobei ein thermoelektrischer Generator (TEG) (3) mit einer Heißseite und einer Kaltseite vorgesehen ist, wobei die Heißseite an die Abgasanlage (1) angeordnet und von einem Abgas der Brennkraftmaschine (2) aufheizbar ist und wobei zwischen der Heißseite und dem Abgasstrom ein erster Wärmetauscher mit einer ersten Wärmeleitfähigkeit angeordnet ist,
**dadurch gekennzeichnet, dass** zumindest ein zweiter TEG (4) an die Abgasanlage (1) angeordnet ist, mit einem zweiten Wärmetauscher mit einer der ersten Wärmeleitfähigkeit ungleichen Wärmeleitfähigkeit, wobei
- die Abgasanlage 1 zumindest einen ersten und einen zweiten, in Strömungsrichtung des Abgases hintereinander angeordneten Bypass (1', 1") aufweist, wobei der erste TEG (3) in Strömungsrichtung des Abgases in dem ersten Bypass (1') und der zweite TEG (4) in dem zweiten Bypass (1") angeordnet ist und wobei in zumindest einem Bypass (1', 1") ein Verschlusselement für das Abgas vorgesehen ist oder wobei
- der erste und der zweite TEG (3, 4) parallel zueinander in dem Bypass (1') angeordnet sind, wobei jeder TEG (3, 4) von dem Abgas aufheizbar ist, wobei zumindest einem TEG (3, 4) ein Verschlusselement (5) für das Abgas zugeordnet ist.

2. Abgasanlage nach Patentanspruch 1,
**dadurch gekennzeichnet, dass** der erste TEG (3) den Wärmetauscher mit der kleineren Wärmeleitfähigkeit und der zweite TEG (4) den Wärmetauscher mit der größeren Wärmeleitfähigkeit aufweist.

3. Abgasanlage nach Patentanspruch 1, wobei das Abgas der Brennkraftmaschine eine von einem Betriebspunkt abhängige, kältere oder heißere Temperatur aufweist,
**dadurch gekennzeichnet, dass** das zumindest eine Verschlusselement (5) derart schaltbar ist, dass heißere Abgas zu dem TEG (3, 4) mit dem Wärmetauscher mit der kleineren Wärmeleitfähigkeit leitbar ist.

4. Abgasanlage nach einem der Patentansprüche 1 bis 3,
**dadurch gekennzeichnet, dass** das zumindest eine Verschlusselement (5) von einem Steuergerät (6) ansteuerbar ist.

5. Abgasanlage nach einem der Patentansprüche 1 bis 4,
**dadurch gekennzeichnet, dass** die Kaltseite des TEG (3, 4) in einen Kühlmittelkreislauf (7) eingebunden ist.

6. Abgasanlage nach einem der Patentansprüche 1 bis 5,
**dadurch gekennzeichnet, dass** in der Abgasanlage (1) ein weiteres Verschlusselement (5') angeordnet ist und das weitere Verschlusselement (5') derart steuerbar ist, dass das gesamte Abgas durch den Bypass (1', 1") strömt.

## Claims

1. An exhaust system (1) for an internal combustion engine (2), wherein a thermoelectric generator (TEG) (3) has a hot side and a cold side, wherein the hot side is disposed on the exhaust system (1) and is heatable by exhaust gas from the engine (2) and wherein a first heat exchanger having a first heat conductivity is disposed between the hot side and the stream of exhaust gas, **characterised in that** at least one second TEG (4) is disposed on the exhaust system (1) and has a second heat exchanger having a different heat conductivity from the first, wherein
- the exhaust system (1) has at least one first and one second bypass (1' 1") disposed one behind the other in the direction of flow of the exhaust gas, wherein the first TEG (3) is disposed in the first bypass (1') in the direction of flow of the exhaust gas and the second TEG (4) is disposed in the second bypass (1"), and wherein a closure element for the exhaust gas is provided in at least one bypass (1', 1") or wherein
- the first and the second TEG (3, 4) are disposed parallel to one another in the bypass (1'), wherein each TEG (3, 4) is heatable by the exhaust gas, wherein a closure element (5) for the exhaust gas is associated with at least one TEG (3, 4).

2. An exhaust system according to claim 1, **characterised in that** the first TEG (3) comprises the heat exchanger having the smaller heat conductivity, and the second TEG (4) comprises the heat exchanger having the greater heat conductivity.

3. An exhaust system according to claim 1, wherein the exhaust gas from the engine has a colder or hotter temperature depending on an operating point, **characterised in that** the at least one closure element (5) is switchable so that hotter exhaust gas can be supplied to the TEG (3, 4) comprising the heat exchanger having the smaller heat conductivity.

4. An exhaust system according to any of claims 1 to 3, **characterised in that** the at least one closure element (5) is actuated by a control device (6).

5. An exhaust system according to any of claims 1 to 4, **characterised in that** the cold side of the TEG (3, 4) is incorporated in a coolant circuit (7).

6. An exhaust system according to any of claims 1 to 5, **characterised in that** an additional closure element (5') is disposed in the exhaust system (1), and the additional closure element (5') can be actuated so that all the exhaust gas flows through the bypass (1', 1").

## Revendications

1. Installation de gaz d'échappement (1) de moteur à combustion interne (2), dans laquelle :
un générateur thermoélectrique (TEG) (3) a un côté chaud et un côté froid,
- le côté chaud prévu pour l'installation de gaz d'échappement (1) est chauffé par les gaz d'échappement du moteur à combustion interne (2), et
- un premier échangeur de chaleur ayant une première conductivité thermique est prévu entre le côté chaud et la veine des gaz d'échappement,
installation **caractérisée en ce que**
- au moins un second générateur (TEG) (4) est prévu pour l'installation de gaz d'échappement (1) comportant un second échangeur de
- chaleur ayant une conductivité thermique différente de la première conductivité thermique,
* l'installation de gaz d'échappement (1) ayant au moins une première et une seconde dérivation (1', 1") l'une derrière l'autre, selon le sens de passage des gaz d'échappement,
* le premier générateur (TEG) (3) étant installé dans la première dérivation (1') selon le sens de passage des gaz d'échappement et le second générateur (TEG) (4) étant installé dans la seconde dérivation (1"), et
* un élément de fermeture pour les gaz d'échappement équipant au moins une dérivation (1', 1"), ou
* le premier et le second générateur (TEG) (3, 4) sont installés en parallèle dans la dérivation (1'),
* chacun des générateurs (TEG) (3, 4) étant chauffé par les gaz d'échappement,
* au moins un générateur (TEG) (3, 4) comportant un élément de fermeture (5) pour les gaz d'échappement.

2. Installation de gaz d'échappement selon la revendication 1,
**caractérisée en ce que**
le premier générateur (TEG) (3) est équipé de l'échangeur de chaleur ayant la plus petite conductivité thermique et le second générateur (TEG) (4) a l'échangeur de chaleur avec la plus grande conductivité thermique.

3. Installation de gaz d'échappement selon la revendication 1, dans laquelle,
les gaz d'échappement du moteur à combustion interne ont une température plus froide ou plus chaude dépendant d'un point de fonctionnement,
**caractérisée en ce qu'**
au moins un élément de fermeture (5) est commuté pour que les gaz d'échappement les plus chauds soient appliqués au générateur (TEG) (3, 4) dans l'échangeur de chaleur ayant la plus petite conductivité thermique.

4. Installation de gaz d'échappement selon l'une des revendications 1 à 3,
**caractérisée en ce qu'**
au moins un élément de fermeture (5) est commandé par un appareil de commande (6).

5. Installation de gaz d'échappement selon l'une des revendications 1 à 4,
**caractérisée en ce que**
le côté froid du générateur (TEG) (3, 4) est intégré dans un circuit d'agent de refroidissement (7).

6. Installation de gaz d'échappement selon l'une des revendications 1 à 5,
**caractérisée en ce que**
l'installation de gaz d'échappement (1) comporte un autre élément de fermeture (5') qui est commandé pour que tous les gaz d'échappement traversent la dérivation (1', 1").
